# EUROPÄISCHE PATENTSCHRIFT

(11) **EP 4 051 851 B1**
(45) Veröffentlichungstag und Bekanntmachung des Hinweises auf die Patenterteilung: **25.06.2025**
(21) Anmeldenummer: 20796803.3
(22) Anmeldetag: 23.10.2020
(51) Int. Cl.: E04G 11/48, E04G 17/00, E04G 5/00, E04G 5/16, E04G 25/00, E04G 1/02, G01D 21/00

(54) **COMPUTERGESTÜTZTES VERFAHREN UND SYSTEM ZUR ERMITTLUNG UND VISUALISIERUNG VON KRAFTFLÜSSEN IN EINEM BAUGERÜST**
COMPUTER-AIDED METHOD AND SYSTEM FOR THE DETERMINATION AND VISUALIZATION OF FORCE FLOWS IN A SCAFFOLD
PROCÉDÉ ET SYSTÈME ASSISTÉS PAR ORDINATEUR POUR DÉTERMINER ET VISUALISER LES FLUX DE FORCE DANS UN ÉCHAFAUDAGE

(30) Priorität: 30.10.2019 DE 102019216792
(43) Veröffentlichungstag der Anmeldung: 07.09.2022
(73) Patentinhaber: PERI SE, 89264 Weißenhorn (DE)
(72) Erfinder: SPAN, Wolfgang, 89264 Weißenhorn (DE); STAVES, Henning, 89264 Weißenhorn (DE)
(74) Vertreter: Holzwarth-Rochford, Andreas
(86) Internationale Anmeldenummer: PCT/EP2020/079861
(87) Internationale Veröffentlichungsnummer: WO 2021/083796

(56) Entgegenhaltungen:
- JIAN SU ET AL: "Development of the IoT-based Monitoring System for Scaffold Shoring System of Concrete Formwork", MATEC WEB OF CONFERENCES, vol. 175, 2 July 2018 (2018-07-02), pages 03072, XP055769476, ISSN: 2261-236X, DOI: 10.1051/matecconf/201817503072
- CHRISTOPHER ULLRICH: "Implementation of sensor technology in scaffolding - An application of technological brokering and smart product design MSc in Innovation and Entrepreneurship", 20 May 2016 (2016-05-20), XP055768605, Retrieved from the Internet <URL:https://www.duo.uio.no/bitstream/handle/10852/51727/Implementation-of-sensor-technology-in-scaffolding.pdf?sequence=1&isAllowed=y> [retrieved on 20210125]
- CHUNHEE CHO ET AL: "Machine Learning for Assessing Real-Time Safety Conditions of Scaffolds", 35TH INTERNATIONAL SYMPOSIUM ON AUTOMATION AND ROBOTICS IN CONSTRUCTION (ISARC 2018), 22 July 2018 (2018-07-22), XP055768604, ISSN: 2413-5844, DOI: 10.22260/ISARC2018/0008
- JIEMING LI ET AL: "Research on the monitoring method for vertical displacement of formwork support system", IOP CONFERENCE SERIES: MATERIALS SCIENCE AND ENGINEERING, vol. 392, 1 July 2018 (2018-07-01), GB, pages 062001, XP055769470, ISSN: 1757-8981, DOI: 10.1088/1757-899X/392/6/062001

## Beschreibung

### Bezugnahme auf verwandte Anmeldungen

Die vorliegende Anmeldung beansprucht die Priorität der deutschen Patentanmeldung Nr. 10 2019 216 792.6, eingereicht am 30. Oktober 2019.

Die vorliegende Erfindung betrifft ein System zur Ermittlung und Visualisierung von zumindest Kraftflüssen, aber optional auch Momentverläufen, in einem Stabtragwerk, das beispielsweise in Form eines Baugerüsts ausgebildet sein kann und mehrere senkrecht verlaufende und beabstandet zueinander aufgestellte Leitern oder Stützenelemente umfasst, die mit hierzu diagonal und/oder waagerecht verlaufenden Strebenelementen lösbar über Gerüstkupplungen verbunden sind. Außerdem betrifft die Erfindung auch ein computergestütztes Verfahren zur Planung der Anordnung von Belastungssensoren in einem solchen Stabtragwerk sowie ein computergestütztes Verfahren zur Betriebsüberwachung des Stabtragwerks mit eingebauten Belastungssensoren. Ferner betrifft die Erfindung Computerprogramme.

Das Einsatzgebiet der Erfindung erstreckt sich auf die Erstellung und Überwachung von sensorbestückten Stabtragwerken, die als Hilfskonstruktion in Form eines Baugerüsts, beispielsweise eines Arbeitsgerüsts, Schutzgerüsts oder Lehrgerüsts ausgebildet sein kann, und in der Regel dafür verwendet wird, im Bau befindliche oder zu sanierende Gebäudeteile, insbesondere Gebäudefassaden, für Bauarbeiter zugänglich zu machen. Außerdem erstreckt sich die Erfindung auch auf Anwendungen von Stabtragwerken in Form von Deckenstützen, Richtstützen sowie auch auf Kletterwerke oder Tunnelschalungen.

### Stand der Technik

Aus dem allgemeinen Stand der Technik gehen die hier interessierenden Systemgerüste hervor, welche im Wesentlichen aus senkrechten Leiter- oder Stützenelementen und hierzu diagonal oder waagerecht quer verlaufenden Strebenelementen bestehen, die mit Gerüstkupplungen lösbar zusammengehalten sind. Als Gerüstkupplungen kommen beispielsweise Drehkupplungen oder Parallelkupplungen zum Einsatz. Die vorstehend genannten Bauelemente werden gemäß eines Baukastensystems bereitgestellt und lassen sich je nach einzurüstendem Gebäudeteil zu unterschiedlichen Baugerüsten kombinieren.

Gemäß geltender Vorschriften, wie beispielsweise vom Deutschen Institut für Bautechnik (DIBt), besteht für den Planer und Verwender von Baugerüsten die Pflicht, einen statischen Nachweis durch entsprechende allgemein bekannte Berechnungen des dem Baugerüst zugrundeliegenden Stabtragwerks zu erbringen. Allerdings kann sich in der Praxis eine Überlastung eines erstellten Baugerüsts dadurch ergeben, dass beispielsweise Traglasten überschritten werden, oder dass sich Verbindungselemente im Bereich von Knotenpunkten lösen. Derartige Ereignisse gefährden die Sicherheit auf der Baustelle.

XP055769476 offenbart ein System zur Ermittlung und Visualisierung von Kraftflüssen in einem Stabtragwerk.

Es ist daher die Aufgabe der vorliegenden Erfindung, ein System sowie ein hierzu korrespondierendes Verfahren zu erschaffen, mit welchem sich in einfacher Weise die aktuelle Belastungssituation eines Baugerüsts überwachen lässt.

### Offenbarung der Erfindung

Die Aufgabe wird ausgehend von einem System gemäß dem Oberbegriff von Anspruch 1 in Verbindung mit dessen kennzeichnenden Merkmalen gelöst. Hinsichtlich eines computergestützten Verfahrens zur Planung der Anordnung von Belastungssensoren in einem ein Baugerüst repräsentierendes Stabtragwerk wird auf Anspruch 11 verwiesen.

Die Ansprüche 17 und 18
sind auf Computerprogramme gerichtet.

Die Erfindung schließt die technische Lehre ein, dass zumindest ein belastungskritischer Teil der Stützenelemente und/oder Strebenelemente und/oder Gerüstkupplungen des Stabtragwerks, welcher sich nach Erfahrungswerten identifizieren lässt, mit Belastungssensoren zur Erfassung von statischen Betriebsbelastungswerten ausgestattet sind, deren Messwerte eine nachgeschaltete Analyseeinheit zum Erkennen von aktuellen Belastungssituationen des Baugerüsts in Echtzeit auswertet. Die erfindungsgemäß vernetzten Belastungssensoren des Stabtragwerks gestatten dabei eine Auswertung hinsichtlich ganz verschiedenartiger Belastungssituationen.

Der Vorteil der erfindungsgemäßen Lösung liegt darin, dass hiermit ein intelligentes Baugerüst geschaffen wird, welches einer messtechnischen Belastungsauswertung zugänglich ist. Dabei brauchen nicht alle Bauelemente des Baugerüsts mit den erfindungsgegenständlichen Belastungssensoren ausgestattet werden, sondern nur der belastungskritische Teil. Als belastungskritischer Teil des Baugerüsts gelten diejenigen Bereiche, welche hinsichtlich ihrer Anordnung und Betriebsbelastung einer stärkeren Verbiegung, Abknickung oder dergleichen Verformungen ausgesetzt sind, als die übrigen Bereiche des Baugerüsts. Dieser belastungskritische Teil ergibt sich anhand der statischen Planung und lässt sich beispielsweise auch durch eine Belastungssimulation erkennen.

Die erfindungsgemäße Lösung lässt sich neben herkömmlichen Baugerüsten auch im Zusammenhang mit anderen Tragwerken, beispielsweise Deckenschalungen, Tunnelausbauten oder Brückengerüsten, einsetzen, welche hier mit umfasst sind. Mit Hilfe der Belastungssensorik werden schädigende Kräfte und Momente noch vor einem Schadensfall sichtbar, so dass die Baustellensicherheit hierdurch erheblich verbessert wird. Außerdem kann durch eine Auswertung der Betriebsbelastung eines Baugerüsts auch festgestellt, ob alle hierin verbauten Gerüstelemente unbedingt erforderlich sind, oder ob auch eine Teilabrüstung eines Baugerüsts zur Materialeinsparung erfolgen kann, indem beispielsweise einzelne Stützenelemente demontiert werden. Dies kann beispielsweise in einer späteren Bauphase wünschenswert sein, wenn ein Baugerüst nur noch für wenig beanspruchende Arbeiten genutzt wird. Ferner kann die erfindungsgegenständliche Belastungssensorik auch zur Lebenszyklus-Überwachung von Baugerüstelementen genutzt werden.

Vorzugsweise sind die Belastungssensoren der hier interessierenden Art als Sensorelemente zur Erfassung von Normalkräften, Querkräften und/oder Biegemomenten von Stützen- oder Strebenelementen des Stabtragwerks ausgebildet. Diese können dabei direkt in die Stützen- oder Strebenelemente integriert werden und sind somit vor Beschädigung geschützt. Beispielsweise kann als Sensorelement zur Erfassung von Normalkräften ein Plattensensor zum Einsatz kommen. Dehnmessstreifen an Streben oder Stützen oder direkt am Plattensensor können auch einer Biegemomenterfassung dienen.

Gemäß einer bevorzugten Ausführungsform ist vorgesehen, dass der zur Erfassung von Normalkräften vorgesehene Belastungssensor derart in das zugeordnete Stützenelement integriert angeordnet ist, dass der Belastungssensor zwischen einem unteren und einem oberen Teil oder an einem der Enden des Stützelements platziert ist, um auf das Stützelement einwirkende Druck- und Zugkräfte aufzunehmen. Mit anderen Worten ist der Belastungssensor damit in Sandwichanordnung mit dem Stützelement kombiniert. Um bei dieser Anordnung ein Einknicken des Stützelementes zu vermeiden, kann beispielsweise ein zentraler Führungsbolzen oder dergleichen die beiden Teile des Stützelementes miteinander axial beweglich verbinden. Der für diese Anordnung vorgesehene Belastungssensor kann als Anbauteil konzipiert sein, um Stützelemente nachträglich hiermit auszurüsten.

Daneben ist es auch möglich, Belastungssensoren zur Erfassung von insbesondere Biegemomenten in Gerüstkupplungen zu integrieren, da diese gewöhnlich die Knotenpunkte des zugrunde liegenden Stabtragwerks verkörpern, in denen maximale Biegemomente auftreten, die eine wesentliche Belastungsinformation darstellen.

Die an eine derartige Belastungssensorik angeschlossene Analyseeinheit gibt gemäß einer die Erfindung weiter verbessernden Maßnahme im Falle einer durch Vergleich der aktuellen Belastungssituation A mit einer vordefinierten Grenzbelastungssituation G ermittelte Überlastung Ü des Stabtragwerks während dessen Betrieb über einen geeigneten Kommunikationskanal eine Warnmeldung an einen Verantwortlichen auf der Baustelle aus.

Ist die Analyseeinheit direkt lokal am Baugerüst angeordnet, so kann dies insbesondere durch akustische Signalisierung vor Ort erfolgen. Ist die Analyseeinheit an zentraler Stelle angeordnet und über einen beispielsweise auf Datenfunk basierenden Kommunikationskanal mit der lokalen Belastungssensorik verbunden, so kann die Warnmeldung im Falle einer Überlastung per bidirektionaler Kommunikation auf einem Rückkanal an die Baustelle übertragen werden. Dies kann beispielsweise auch an ein mobiles Endgerät eines Baustellenverantwortlichen erfolgen.

Gemäß einer bevorzugten Ausführungsform kann die zentrale oder lokale Analyseeinheit mit einer grafischen Monitoreinheit zur Visualisierung von verschieden starken Belastungsbereichen des Stabtragwerks verbunden sein. Die Belastungsbereiche können sich im Planungsstadium für die Anordnung von Belastungssensoren beispielsweise aus einer Belastungssimulation ergeben und werden während des Betriebs eines Baugerüsts durch die permanente Messwertauswertung zur Verfügung gestellt.

Die Monitoreinheit zur Visualisierung von verschieden starken Belastungsbereichen des Stabtragwerks kann auch vor Ort auf der Baustelle Bestandteil eines mobilen Endgeräts sein, um eine unmittelbare Beurteilung vornehmen zu können.

Gemäß einer die Erfindung weiterbildenden Maßnahme wird vorgeschlagen, dass das mobile Endgerät mit Nahbereichsdetektionsmitteln zum lokalen Auslesen des Messwerts eines einzelnen Belastungssensors ausgestattet ist. Solche Nahbereichsdetektionsmittel können zur Identifikation des Belastungssensors beispielseise einen QR-Code-Leser, RFID-Cip oder dergleichen enthalten und seitens des Belastungssensors ist ein entsprechendder QR-Code oder RFID-Transponder als optisches beziehungsweise elektronisches Identifikationsmittel vorgesehen. Hierüber lässt sich eine Einzelwerterfassung von Belastungsdaten vor Ort durchführen. Das mobile Endgerät kann zudem dazu eingerichtet sein, eine Summenbildung eingelesener Einzelwerte zur Ermittlung und Ausgabe einer Gesamtlast(-verteilung) vorzunehmen. In Ergebnis dessen lassen sich beispielsweise Betonierzyklen erfassen und zu Dokumentationszwecken in einfacher Weise abspeichern und an die zentrale Speichereinheit zum Archivieren übertragen.

Alternativ hierzu ist es jedoch auch möglich, zumindest die Analyseeinheit des erfindungsgegenständlichen Systems als Bestandteil einer zentralen Servereinrichtung auszubilden, die über mindestens einen Kommunikationskanal an die lokalen Belastungssensoren des Baugerüsts auf der Baustelle angeschlossen ist. Bei dieser Konfiguration lässt sich also eine zentral bereitgestellte Rechnerkapazität auslasten. Die zentrale Servereinrichtung bildet ferner eine optionale Voraussetzung dafür, aus der Analyseeinheit gewonnene Lerndaten aktueller Überwachungsvorgänge auf einer zugeordneten Speichereinheit zu unterlegen, womit beispielsweise zukünftige Planungen von Sensoranordnungen in gleichen oder ähnlichen Stabtragwerken unterstützt werden können.

Gemäß der Erfindun ist vorgesehen, dass das System ferner eine Planungseinheit zur Planung der Anordnung von Belastungssensoren in einem Stabtragwerk umfasst, welche die dieser eingangsseitig zugeführten Daten der statischen Planung verarbeitet. Hierdurch lässt sich mit dem nachfolgend beschriebenen Verfahren die Anordnung von Belastungssensoren in einem Baugerüst in einfacher Weise planen:
Ein computergestütztes Verfahren zur Planung der Anordnung von Belastungssensoren in einem Stabtragwerk des vorstehend beschriebenen Systems umfasst die Schritte, gemäß Anspruch 11.

Außerdem umfasst die Planung der überwachungsgerecht zu positionierenden Belastungssensoren auch eine anschließende Anschlussplanung einer geeigneten zentralen oder lokalen Analyseeinheit zur Messsignalauswertung.

Ist auf der Baustelle ein auf diese Weise geplantes Baugerüst erstellt worden, so kann anschließend die gewünschte Betriebsüberwachung hinsichtlich Überlastung erfolgen, welche die folgenden wesentlichen Schritte umfasst:
- Kontinuierliche Erfassung von Messdaten der Belastungssensoren im Stabtragwerk durch die Analyseeinheit,
- Auswertung der erfassten Messdaten hinsichtlich Überlastungssituationen des Stabtragwerks während des Betriebs.

Dies bildet die Voraussetzung dafür, dass bei Eintritt einer Überlastungssituation eine optionale Warnmeldung an den Verantwortlichen auf der Baustelle zur Gefahrenabwehr ausgegeben werden kann.

Zur erweiterten Belastungsüberwachung können die Messdaten der in den Stützenelementen integrierten oder hieran angeordneten Belastungssensoren auch dahingehend ausgewertet werden, dass eine Anwesenheit und/oder Bewegung von auf dem Baugerüst befindlichen Personen ermittelt wird. Hierdurch lässt sich beispielsweise eine drohende Gerüstüberlastung bei Überschreitung einer maximal zulässigen Personenanzahl erkennen. Zudem können temporäre Lastdifferenzen zwischen Stützelementen auch Daten über Bewegungen auf dem Baugerüst liefern, um beispielsweise Informationen über den Baufortschritt zu gewinnen.

Ferner können die Messdaten auch hinsichtlich eines Vorhandenseins von zusätzlichen Gegenständen auf dem Baugerüst ausgewertet werden. Dies können beispielsweisen Paletten, Baustoffe oder Gerüstmaterial sein. Üblicherweise handelt es sich dabei um Lasten, die über eine längere Zeit unbeweglich lagern und somit eine zusätzliche lokale statische Last bilden. Diese lokale statische Last lässt sich, wie auch die beweglichen (Personen-)Lasten, in übersichtlicher Weise auch graphisch auf einem mobilen Endgerät vor Ort oder einer zentralen Monitoringinstanz zu Überwachungszwecken darstellen.

Außerdem ist es denkbar, dass im Rahmen der Belastungsüberwachung die Messdaten der in den Stützenelementen integrierten oder hieran angeordneten Belastungssensoren dahingehend ausgewertet werden, dass per Plausibilitätsprüfung unzulässig positionierte, insbesondere unzulässig schrägstehende Stützeneemente identifiziert werden. Denn weicht bei einer Gruppe von erwartungsgemäß gleichbelasteten Stützelementen ein Stützelement durch einen ungewöhnlich geringeren Lastmesswert auf, so kann dies auf eine Schrägstellung hindeuten.

Ferner kann durch einen Vergleich der Messdaten benachbarter Stützelemente auch der Baufortschritt einer von diesen getragenen Flächenlast ermittelt werden, beispielsweise beim abschnittsweise Betonieren einer Zwischendecke eines Gebäudes. Dies kann in Form sogenannter Livedaten vor Ort ausgegeben werden, um beispielsweise unzulässig ungleichmäßige Lastverteilungen frühzeitig zu erkennen, so dass diese gegebenenfalls korrigiert werden können ehe ein Baumangel und/oder eine Gerüstüberlastung entsteht.

Das computergestützte Verfahren zur Planung der Anordnung der Belastungssensoren lässt sich durch ein entsprechendes Computerprogramm realisieren, dessen Befehle sich auf der vorstehend erwähnten Planungseinheit ausführen lassen.

Das Verfahren zur Betriebsüberwachung des Stabtragwerks mit den Belastungssensoren lässt sich als Computerprogramm realisieren, welches auf der vorstehend angegebenen Analyseeinheit ausgeführt wird, die Bestandteil einer zentralen Servereinrichtung ist.

### Detailbeschreibung der Zeichnung

Weitere die Erfindung verbessernde Maßnahmen werden nachstehend gemeinsam mit der Beschreibung eines bevorzugten Ausführungsbeispiels der Erfindung anhand der Figuren näher dargestellt. Es zeigt:
- Fig. 1: eine schematische perspektivische Darstellung eines Baugerüsts zum Abstützen von Schalungsplatten zur Betonierung eines Gebäudeteils,
- Fig. 2: eine perspektivische Darstellung eines Teils des Baugerüsts gemäß Fig. 1,
- Fig. 3: eine schematische Darstellung eines Systems zur Ermittlung und Visualisierung von Kraftflüssen in dem das Baugerüst repräsentierenden Stabtragwerk,
- Fig. 4: einen Ablaufplan eines computergestützten Verfahrens zur Planung der Anordnung von Belastungssensoren in dem Stabtragwerk, und
- Fig. 5: einen Ablaufplan des computergestützten Verfahrens zur Betriebsüberwachung des Stabtragwerks.

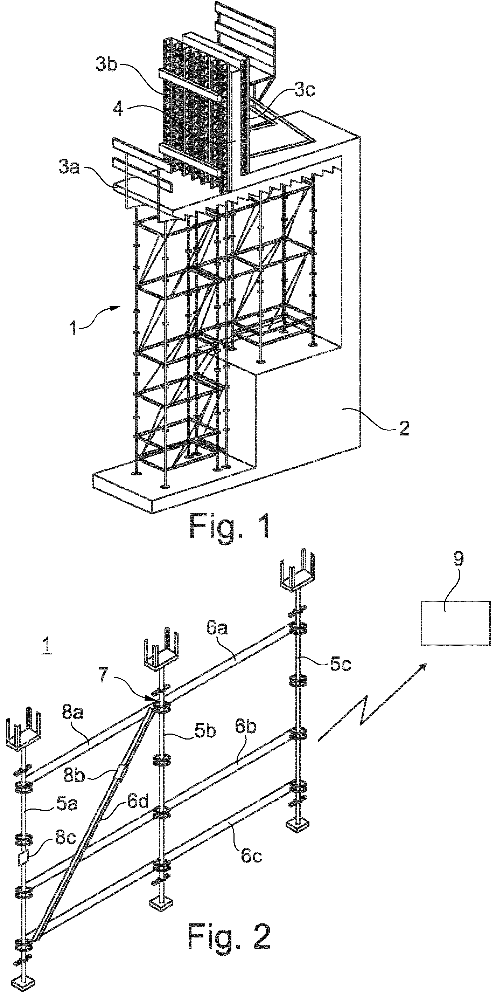

Gemäß Fig. 1 ist ein Stabtragwerk 1 in Form eines Baugerüsts an einem Gebäudeteil 2 montiert. In dieser Anordnung dient das Stabtragwerk 1 der Unterstützung eines Schalungselements 3a, das mit zwei weiteren Schalungselementen 3b und 3c kombiniert ist, um hiermit einen Wandabschnitt 4 des Gebäudeteils 2 zu betonieren.

Die Fig. 2 stellt einen exemplarischen Teil des Baugerüsts und damit des Stabtragwerks 1 dar. Dieses umfasst insgesamt drei beabstandet zueinander angeordnete senkrechte Stützenelemente 5a bis 5c, die mit drei hierzu quer verlaufenden waagerechten Strebenelementen 6a bis 6c und einem zwischen den senkrechten Stützenelementen 5a und 5b diagonal verlaufenden Strebenelement 6d zur Stabilisierung zusammengesetzt ist. Die einzelnen Bauelemente sind mit üblichen Gerüstkupplungen 7 (exemplarisch) lösbar miteinander verbunden.

### Der dargestellte Bereich des Stabtragwerks 1 bildet einen belastungskritischen Teil des

Baugerüsts, welcher mit Belastungssensoren 8a bis 8c (exemplarisch) versehen ist, die jeweils in die Baugerüstelemente integriert angeordnet sind. Die einzelnen Belastungssensoren 8a bis 8c nehmen die Bauteilspannungen während des Einsatzes des Baugerüsts auf und leiten diese über einen zumindest teilweise drahtlos ausgebildeten Kommunikationskanal an eine ortsfern angeordnete zentrale Analyseeinheit 9 zur Auswertung von aktuellen Belastungssituationen des Baugerüsts weiter.

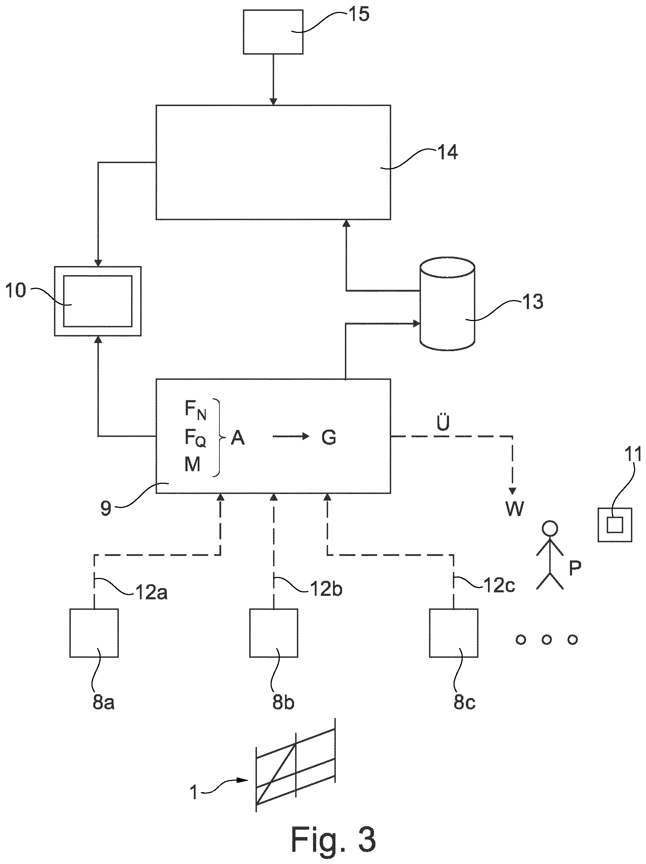

Gemäß Fig. 3 umfasst das hier in Form eines Blockschaltbilds veranschaulichte System zur Ermittlung und Visualisierung von Kraftflüssen im Stabtragwerk 1 die mehreren vorstehend angegebenen Belastungssensoren 8a bis 8c des Stabtragwerks 1.

Die Analyseeinheit 9 ermittelt aus den Messwerten die Normalkräfte F_{N}, die Querkräfte F_{Q} sowie Biegemomente M_{B} im Stabtragwerk 1, welche die aktuelle Belastungssituation A des Baugerüsts repräsentieren. Die aktuelle Belastungssituation A wird mit einer vordefinierten Grenzbelastungssituation G verglichen, um bei Überschreiten derselben eine Überlastung Ü des Stabtragwerks 1 festzustellen. Eine solche Überlastung Ü wird anschließend über einen Rückübertragungs-Kommunikationskanal als Warnmeldung W an einen Verantwortlichen P auf der Baustelle übertragen. Dies kann beispielsweise per Signalisierung auf einem mobilen Endgerät 11 des Verantwortlichen P per App oder einem Messenger erfolgen. Hierdurch bekommt der Verantwortliche P auf der Baustelle die Gelegenheit, auf die signalisierte Überlastung Ü unfallvermeidend zu reagieren.

Zu Überwachungszwecken ist die zentrale Analyseeinheit 9 mit einer in der App des mobilen Endgeräts 11 des Verantwortlichen P integrierten grafischen Monitoreinheit zur Visualisierung von Belastungssituationen des Stabtragwerks 1 verbunden. Daneben lässt sich die aktuelle Belastungssituation auch über eine im Bereich der zentralen Analyseeinheit 9 angeordneten weiteren Monitoreinheit 11 zentral visuell überwachen.

Die Analyseeinheit 9 ist als zentraler Bestandteil einer Servereinrichtung über sensorindividuelle Kommunikationskanäle 12a bis 12c an die lokalen Belastungssensoren 8a bis 8c des das Stabtragwerk 1 repräsentierende Baugerüst auf der Baustelle angeschlossen.

Weiterhin ist die Analyseeinheit 9 mit einer Speichereinheit 13 zur Hinterlegung von Lerndaten für die Unterstützung zukünftiger Planungen von Sensoranordnung in gleichen oder ähnlichen Stabtragwerken 1' verbunden.

Zu diesem Zwecke ist als weiterer Bestandteil der zentralen Servereinrichtung eine Planungseinheit 14 vorgesehen. Die Planungseinheit 14 ist für eine Planung der Anordnung der Belastungssensoren 8a bis 8c in dem Stabtragwerk 1 vorgesehen, welche also die Voraussetzung für die anschließende Realisierung und Überwachung schafft. Insoweit hat die mit der Planungseinheit 14 auszuführende Planung vor der Belastungsüberwachung zu erfolgen. Die Planungseinheit 14 steht dabei ebenfalls mit der grafischen Monitoreinheit 10 zur Visualisierung der Einbauplanung in Verbindung und nutzt zur Durchführung der Planungsaufgabe die aus der statischen Planung 15 des Stabtragwerks 1 resultierenden Dimensionierungsdaten.

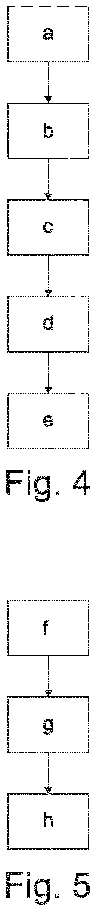

In der Fig. 4 ist das insoweit computergestützte Verfahren zur Planung der Anordnung von Belastungssensoren 8a bis 8c in einem Stabtragwerk 1 des vorstehend beschriebenen Systems veranschaulicht. Es werden die folgenden Schritte ausgeführt, wobei sich die Bezugszeichen auf die Systemdarstellung gemäß Fig. 3 beziehen:
Initial ist eine Bereitstellung a einer statischen Planung 15 des als Baugerüst auszuführenden Stabtragwerks 1 erforderlich. Hiervon ausgehend erfolgt anschließend ein Identifizieren b von überlastungsgefährdeten Lastbereichen im Stabtragwerk 1, beispielsweise per Belastungssimulation. Davon wiederum ausgehend wird eine Auswahl c von geeigneten Belastungssensoren 8a bis 8c durchgeführt, die für die Belastungserfassung an den betreffenden Gerüstteilen im identifizierten überlastungsgefährdeten Lastbereich geeignet sind. Die ausgewählten Belastungssensoren 8a bis 8c werden schließlich durch Positionieren D in dem überlastungsgefährdeten Lastbereich des Stabtragwerks 1 angeordnet, um hierin die aktuelle Belastungssituation messen zu können. Schließlich ist im Rahmen der Planung ein Bestimmen e der Datenverbindung an die Analyseeinheit 9 durchzuführen, welche beispielsweise per Datenfunk, Mobilfunk, WLAN über gerichtete Verbindungskanäle oder zumindest teilweise Nutzung des Internet erfolgen kann. Im Falle einer lokal auf der Baustelle angeordneten Analyseeinheit 9 kann dies durchaus auch per herkömmlicher Drahtverbindung erfolgen.

Die Fig. 5 zeigt die wesentliche Schrittabfolge einer anschließenden Betriebsüberwachung des Stabtragwerks 1 mit den Belastungssensoren 8a bis 8c, bei welcher eine kontinuierliche Erfassung f von Messdaten der Belastungssensoren 8a bis 8c im Stabtragwerk 1 durch die Analyseeinheit 9 durchgeführt wird. Anschließend erfolgt eine Auswertung g der erfassten Messdaten hinsichtlich der Belastungssituation des Stabtragwerks 1 während des Betriebs in vorstehend erörterter Weise. Wird detektiert, dass eine Überlastungssituation h eingetreten ist, so wird eine Warnmeldung an den Verantwortlichen auf der Baustelle zur Gefahrenabwehr ausgegeben.

Sowohl das vorstehend beschriebene Planungsverfahren für die Belastungssensoranordnung im Stabtragwerk als auch das hierauf basierende anschließende reale Betriebsüberwachungsverfahren des Baugerüsts lassen sich jeweils als Software ausführen, welche auf der jeweils als Rechnereinheiten ausgebildeten Planungseinheit 14 bzw. der Analyseeinheit 9 der zentralen Servereinrichtung oder anderswo ausgeführt werden.

Die Erfindung ist nicht beschränkt auf das vorstehend beschriebene bevorzugte Ausführungsbeispiel. Es sind vielmehr auch Abwandlungen hiervon denkbar, welche ebenfalls vom Schutzbereich der nachfolgenden Ansprüche mit umfasst sind.

### Bezugszeichenliste

- 1: Stabtragwerk
- 2: Gebäudeteil
- 3: Schalungselemente
- 4: Wandabschnitt
- 5: Leiter- oder Stützenelemente
- 6: Strebenelemente
- 7: Gerüstkupplung
- 8: Belastungssensor
- 9: Analyseeinheit
- 10: Monitoreinheit
- 11: mobiles Endgerät
- 12: Kommunikationskanal
- 13: Speichereinheit
- 14: Planungseinheit
- 15: statische Planung

- F_{N}: Normalkraft
- F_{Q}: Querkraft
- M_{B}: Biegemoment

- A: aktuelle Belastungssituation
- G: vordefinierte Grenzbelastungssituation
- Ü: ermittelte Überlastung
- W: Warnmeldung
- P: Verantwortlicher auf Baustelle

## Patentansprüche

1. System zur Ermittlung und Visualisierung von Kraftflüssen in einem Stabtragwerk (1), das vorzugsweise in Form eines Baugerüsts ausgebildet ist, umfassend mehrere senkrecht verlaufende und beanstandet zueinander aufgestellte Leiter- oder Stützenelemente (5a - 5c), die mit hierzu diagonal und/oder waagerecht querverlaufende Strebenelemente (6a - 6d) lösbar über Gerüstkupplungen (7) verbunden sind, wobei
zumindest ein belastungskritischer Teil der Stützenelemente (5a - 5c) und/oder Strebenelemente (6a - 6d) und/oder Gerüstkupplungen (7) des Stabtragwerks (1) mit Belastungssensoren (8a - 8c) zum Erfassen von statischen Betriebsbelastungswerten ausgestattet sind, deren Messwerte eine nachgeschaltete Analyseeinheit (9) zur Auswertung von aktuellen Belastungssituationen in Echtzeit analysiert,
**dadurch gekennzeichnet, dass** die Analyseeinheit (9) mit einer Speichereinheit (13) zur Hinterlegung von Lerndaten für die Unterstützung zukünftiger Planungen von Sensoranordnungen in gleichen oder ähnlichen Stabtragwerken (1) verbunden ist, wobei eine auf die Speichereinheit (13) zugreifende Planungseinheit (14) zur Planung der Anordnung von Belastungssensoren (8a - 8c) in einem Stabtragwerk (1) vorgesehen ist, welche Dimensionierungsdaten einer statischen Planung (15) verarbeitet.

2. System nach Anspruch 1,
**dadurch gekennzeichnet, dass** die Belastungssensoren (8a - 8c) als Sensorelemente zur Erfassung von Normalkräften (F_{N}), Querkräften (F_{Q}) und/oder Biegemomenten (M_{B}) von Stützen- oder Strebenelementen (5a - 5c; 6a - 6d) im Stabtragwerk (1) ausgebildet sind.

3. System nach Anspruch 2,
**dadurch gekennzeichnet, dass** der zur Erfassung von Normalkräften (F_{N}) vorgesehene Belastungssensor (8c) derart in das zugeordnete Stützenelement (5a; 5b; 5c) integriert angeordnet ist, dass der Belastungssensor (8c) zwischen einem unteren und einem oberen Teil oder an einem der Enden des Stützenelements (5a; 5b; 5c) platziert ist, um auf das Stützenelement (5a; 5b; 5c) einwirkende Druck- und Zugkräfte aufzunehmen.

4. System nach Anspruch 2,
**dadurch gekennzeichnet, dass** Belastungssensoren (8a - 8c) in die Stützen- oder Strebenelementen (5a - 5c; 6a - 6d) integriert angeordnet sind.

5. System nach Anspruch 2,
**dadurch gekennzeichnet, dass** Belastungssensoren (8) zur Erfassung von Biegemomenten (M_{B}) in Gerüstkupplungen (7) integriert sind.

6. System nach Anspruch 1,
**dadurch gekennzeichnet, dass** die Analyseeinheit (9) im Falle einer durch Vergleich der aktuellen Belastungssituation (A) mit einer vordefinierten Grenzbelastungssituation (G) ermittelten Überlastung (Ü) des Stabtragwerks (1) über einen Kommunikationskanal eine Warnmeldung (W) an einen Verantwortlichen (P) auf der Baustelle ausgibt.

7. System nach Anspruch 1,
**dadurch gekennzeichnet, dass** die Analyseeinheit (9) mit einer graphischen Monitoreinheit (10) zur zentralen Visualisierung von Belastungssituationen des Stabtragswerks (1) verbunden ist.

8. System nach Anspruch 1,
**dadurch gekennzeichnet, dass** die aktuelle Belastungssituation über eine seitens der Baustelle angeordnete Monitoreinheit eines mobilen Endgeräts (11) des Verantwortlichen (P) vor Ort überwachter ist.

9. System nach Anspruch 8,
**dadurch gekennzeichnet, dass** das mobile Endgerät (11) mit Nahbereichsdetektionsmitteln zum lokalen Auslesen des Messwerts eines einzelnen Belastungssensors (8a; 8b; 8c) ausgestattet ist, welcher hierzu mit optischen oder elektronischen Identifikationsmitteln ausgestattet ist.

10. System nach Anspruch 1,
**dadurch gekennzeichnet, dass** zumindest die Analyseeinheit (9) Bestandteil einer zentralen Servereinrichtung ist, die über mindestens einen Kommunikationskanal (12a - 12c) an die lokalen Belastungssensoren (8a - 8c) des Baugerüsts angeschlossen ist.

11. Computergestütztes Verfahren zur Planung der Anordnung von Belastungssensoren (8a - 8c) in einem Stabtragwerk (1) sowie zur anschließenden Betriebsüberwachung eines Stabtragwerks (1) mit den Belastungssensoren (8a - 8c) eines Systems nach einem der vorstehenden Ansprüche, umfassend die folgenden Schritte:
- Bereitstellung (a) einer statischen Planung (15) des als Baugerüst auszuführenden Stabtragwerks (1),
- Identifizieren (b) von überlastungsgefährdeten Lastbereichen im Stabtragwerk (1),
- Auswahl (c) von Belastungssensoren (8a - 8c), die für die Belastungserfassung an Stützenelementen (5a - 5c) und/oder Strebenelementen (6a - 6d) und/oder Gerüstkupplungen (7) im identifizierten Lastbereich geeignet sind,
- Positionieren (d) der ausgewählten Belastungssensoren (8a - 8c) im zumindest belastungskritischen Teil des Stabtragwerks (1), für eine
- kontinuierliche Erfassung (f) von Messdaten der Belastungssensoren (8a - 8c) im Stabtragwerk (1) durch die Analyseeinheit (9),
- Auswertung (g) der erfassten Messdaten hinsichtlich Überlastungssituationen des Stabtragwerks (1) während des Betriebs, wobei
- durch die mit der Speichereinheit (13) verbundenen Analyseeinheit (9) Lerndaten für die Unterstützung zukünftiger Planungen von Sensoranordnungen in gleichen oder ähnlichen Stabtragwerken (1) hinterlegt werden, so dass
- mit einer auf die Speichereinheit (13) zugreifenden Planungseinheit (14) die zukünftige Anordnung von Belastungssensoren (8a - 8c) in einem Stabtragwerk (1) geplant wird, welche Dimensionierungsdaten der statischen Planung (15) verarbeitet.

12. Verfahren nach Anspruch 11,
**dadurch gekennzeichnet, dass** ein Bestimmen (e) der Datenverbindung der überwachungsgerecht positionierten Belastungssensoren (8a - 8c) zu der hieran anzuschließenden Analyseeinheit (9) durchgeführt wird.

13. Verfahren nach Anspruch 11,
**dadurch gekennzeichnet, dass** zur erweiterten Belastungsüberwachung die Messdaten der in den Stützenelementen (5a-5c) integrierten oder hieran angeordneten Belastungssensoren (8c) dahingehend ausgewertet werden, dass eine Anwesenheit und/oder Bewegung von auf dem als Baugerüst ausgebildeten Stabtragwerk (1) befindlichen Personen oder ein dortiges Vorhandensein von zusätzlichen Gegenständen ermittelt wird.

14. Verfahren nach Anspruch 11,
**dadurch gekennzeichnet, dass** zur erweiterten Belastungsüberwachung die Messdaten der in den Stützenelementen (5a-5c) integrierten oder hieran angeordneten Belastungssensoren (8c) dahingehend ausgewertet werden, dass per Plausibilitätsprüfung unzulässig positionierte, insbesondere unzulässig schrägstehende Stützenelemente (5a-5c) identifiziert werden.

15. Verfahren nach Anspruch 11,
**dadurch gekennzeichnet, dass** durch einen Vergleich der Messdaten von Belastungssensoren (8c) benachbarter Stützelemente (5a-5c) der Baufortschritt einer von diesen getragenen Flächenlast ermittelt wird.

16. Verfahren nach Anspruch 11,
**dadurch gekennzeichnet, dass** bei Eintritt einer Überlastungssituation (h) eine Warnmeldung an den Verantwortlichen (P) auf der Baustelle zur Gefahrenabwehr ausgegeben wird.

17. Computerprogramm, umfassend Befehle, die bei der Ausführung des Programms durch eine rechnergestützte Planungseinheit (14) diese veranlassen, das Verfahren/die Schritte des Verfahrens nach Anspruch 11 auszuführen.

18. Computerprogramm, umfassend Befehle, die bei der Ausführung des Programms durch eine rechnergestützte Analyseeinheit (9) diese veranlassen, das Verfahren/die Schritte des Verfahrens nach Anspruch 11 auszuführen.

## Claims

1. A system for the determination and visualization of force flows in a bar-type supporting structure (1) which is preferably designed in the form of a scaffold, comprising a plurality of vertically extending ladder or support elements (5a-5c), which are set up at a distance from one another and/or which are detachably connected via scaffold couplings (7) to strut elements (6a-6d) extending transversely in the diagonal and/or horizontal direction to said ladder or support elements, wherein
at least one load-critical part of the support elements (5a-5c) and/or strut elements (6a-6d) and/or scaffold couplings (7) of the bar-type supporting structure (1) is equipped with load sensors (8a-8c) for capturing static operating load values, the measured values of which are analyzed in real time by a downstream analysis unit (9) for evaluating current load situations,
**characterized in that** the analysis unit (9) is connected to a memory unit (13) for storing learning data for supporting future planning of sensor arrangements in the same or similar bar-type supporting structures (1), wherein a planning unit (14) which accesses the memory unit (13) for planning the arrangement of load sensors (8a-8c) in a bar-type supporting structure (1) is provided, which processes dimensioning data of the static planning (15).

2. The system according to Claim 1,
**characterized in that** the load sensors (8a-8c) are designed as sensor elements for capturing normal forces (F_{N}), transverse forces (F_{Q}) and/or bending moments (M_{B}) of support or strut elements (5a-5c; 6a-6d) in the bar-type supporting structure (1).

3. The system according to Claim 2,
**characterized in that** the load sensor (8c) provided for capturing normal forces (F_{N}) is arranged integrated in the associated support element (5a; 5b; 5c) in such a way that the load sensor (8c) is placed between a lower and an upper part or at one of the ends of the support element (5a; 5b; 5c) in order to absorb compressive and tensile forces acting on the support element (5a; 5b; 5c).

4. The system according to Claim 2,
**characterized in that** load sensors (8a-8c) are arranged integrated in the support or strut elements (5a-5c; 6a-6d).

5. The system according to Claim 2,
**characterized in that** load sensors (8) for capturing bending moments (M_{B}) are integrated in scaffold couplings (7).

6. The system according to Claim 1,
**characterized in that,** in the event of an overload (Ü) of the bar-type supporting structure (1) determined by comparing the current load situation (A) with a predefined limit load situation (G), the analysis unit (9) outputs a warning message (W) to a responsible person (P) on the construction site via a communication channel.

7. The system according to Claim 1,
**characterized in that** the analysis unit (9) is connected to a graphic monitor unit (10) for the central visualization of load situations of the bar-type supporting structure (1).

8. The system according to Claim 1,
**characterized in that** the current load situation is monitored on site via a monitor unit of a mobile terminal (11) of the person in charge (P), which is arranged by the construction site.

9. The system according to Claim 8,
**characterized in that** the mobile terminal (11) is equipped with close-range detection means for locally reading out the measured value of a single load sensor (8a; 8b; 8c) which is equipped with optical or electronic identification means for this purpose.

10. The system according to Claim 1,
**characterized in that** at least the analysis unit (9) is part of a central server device which is connected to the local load sensors (8a-8c) of the scaffold via at least one communication channel (12a-12c).

11. A computer-aided method for the planning of the arrangement of load sensors (8a-8c) in a bar-type supporting structure (1) as well as for the subsequent operational monitoring of a bar-type supporting structure (1) with the load sensors (8a-8c) of a system according to any one of the preceding claims, comprising the following steps:
- providing (a) static planning (15) of the bar-type supporting structure (1) to be executed as a scaffold,
- identifying (b) load ranges in the bar-type supporting structure (1), which are at risk of overload,
- selecting (c) load sensors (8a-8c) which are suitable for capturing the load on support elements (5a-5c) and/or strut elements (6a-6d) and/or scaffold couplings (7) in the identified load range,
- positioning (d) the selected load sensors (8a-8c) in the at least load-critical part of the bar-type supporting structure (1), for a
- continual capturing (f) of measurement data from the load sensors (8a-8c) in the bar-type supporting structure (1) by the analysis unit (9),
- evaluating (g) the captured measurement data with regard to overload situations of the bar-type supporting structure (1) during operation, wherein
- learning data for supporting future planning of sensor arrangements in the same or similar bar-type supporting structures (1) are stored by the analysis unit (9) connected to the memory unit (13) so that
- the future arrangement of load sensors (8a-8c) in a bar-type supporting structure (1) is planned with a planning unit (14) which accesses the memory unit (13), which processes dimensioning data of the static planning (15).

12. The method according to Claim 11,
**characterized in that** a determining (e) of the data connection of the load sensors (8a-8c) positioned for monitoring is carried out to the analysis unit (9) to be connected hereto

13. The method according to Claim 11,
**characterized in that** for extended load monitoring, the measurement data of the load sensors (8c) integrated in the support elements (5a-5c) or arranged hereon are evaluated to the effect that a presence and/or movement of persons located on the bar-type supporting structure (1) designed as a scaffold or a presence of additional objects there is determined.

14. The method according to Claim 11,
**characterized in that** for extended load monitoring, the measurement data of the load sensors (8c) integrated in the support elements (5a-5c) or arranged hereon are evaluated to the effect that impermissibly positioned, in particular impermissibly inclined support elements (5a-5c) are identified by means of a plausibility check.

15. The method according to Claim 11,
**characterized in that** by comparing the measurement data of load sensors (8c) of adjacent support elements (5a-5c), the construction progress of an area load carried by said adjacent support elements is determined.

16. The method according to Claim 11,
**characterized in that** when an overload situation (h) occurs, a warning message is issued to the person in charge (P) on the construction site to avert the danger.

17. A computer program comprising commands which, when the program is executed by a computer-aided planning unit (14), prompt the latter to execute the method/the steps of the method according to Claim 11.

18. A computer program, comprising commands which, when the program is executed by a computer-aided analysis unit (9), prompt the latter to execute the method/the steps of the method according to Claim 11.

## Revendications

1. Système pour la détermination et la visualisation de flux de force dans une structure porteuse (1), laquelle est conçue de préférence sous forme d'échafaudage, comprenant plusieurs éléments d'échelle ou de soutien (5a-5c) s'étendant verticalement et dressés à distance les uns des autres, lesquels sont reliés de façon détachable par des accouplements d'échafaudage (7) avec des éléments d'entretoises (6a-6d) s'étendant de façon transversale en diagonale par rapport à ceux-ci et/ou horizontalement,
au moins une partie des éléments de soutien (5a-5c) et/ou des éléments d'entretoises (6a-6d) et/ou des accouplements d'échafaudage (7) de la structure porteuse (1) exposés à la contrainte étant équipés de capteurs de contrainte (8a-8c) pour la saisie de valeurs de contrainte de fonctionnement statiques, dont les valeurs de mesure sont analysées en temps réel par une unité d'analyse (9) en aval pour l'évaluation des situations de contrainte actuelles,
**caractérisé en ce que** l'unité d'analyse (9) est reliée à une unité de stockage (13) pour l'enregistrement de données d'apprentissage pour le soutien à des planifications futures d'agencements de capteurs dans des structures porteuses (1) semblables ou similaires, une unité de planification (14) accédant à l'unité de stockage (13) étant prévue pour la planification de l'agencement de capteurs de contrainte (8a-8c) dans une structure porteuse (1), laquelle traite des données de dimensionnement d'une planification statique (15).

2. Système selon la revendication 1,
**caractérisé en ce que** les capteurs de contrainte (8a-8c) sont conçus comme des éléments de capteurs pour la saisie de forces normales (F_{N}), de forces transversales (F_{Q}) et/ou de moments fléchissants (M_{B}) d'éléments de soutien ou d'entretoises (5a-5c ; 6a-6d) dans la structure porteuse (1).

3. Système selon la revendication 2,
**caractérisé en ce que** le capteur de contrainte (8c) prévu pour la saisie de forces normales (F_{N}) est disposé de façon intégrée dans l'élément de soutien (5a ; 5b ; 5c) attribué de telle sorte que le capteur de contrainte (8c) est placé entre une partie inférieure et une partie supérieure ou à l'une des extrémités de l'élément de soutien (5a ; 5b ; 5c), pour enregistrer des forces de compression ou de traction s'exerçant sur l'élément de soutien (5a ; 5b ; 5c).

4. Système selon la revendication 2,
**caractérisé en ce que** des capteurs de contrainte (8a-8c) sont disposés de façon intégrée dans les éléments de soutien ou d'entretoises (5a-5c ; 6a-6d).

5. Système selon la revendication 2,
**caractérisé en ce que** des capteurs de contrainte (8) sont intégrés pour la saisie de moments fléchissants (M_{B}) dans des accouplements d'échafaudage (7).

6. Système selon la revendication 1,
**caractérisé en ce que** l'unité d'analyse (9) sort un message d'alerte (W) par un canal de communication à l'attention d'un responsable (P) sur le chantier, en cas de surcharge (Ü) de la structure porteuse (1) déterminée par comparaison entre la situation de contrainte (A) actuelle et une situation de contrainte limite (G) prédéfinie.

7. Système selon la revendication 1,
**caractérisé en ce que** l'unité d'analyse (9) est reliée avec une unité de moniteur graphique (10) pour la visualisation centrale de situations de contrainte de la structure porteuse (1).

8. Système selon la revendication 1,
**caractérisé en ce que** la situation de contrainte actuelle est surveillée par une unité de moniteur d'un terminal mobile (11) du responsable (P) sur place, disposée du côté du chantier.

9. Système selon la revendication 8,
**caractérisé en ce que** le terminal mobile (11) est équipé de moyens de détection de proximité pour la lecture locale de la valeur de mesure d'un capteur de contrainte (8a ; 8b ; 8c) individuel, lequel est équipé à cet effet de moyens d'identification optiques ou électroniques.

10. Système selon la revendication 1,
**caractérisé en ce qu'au** moins l'unité d'analyse (9) fait partie d'une installation de serveur centrale, laquelle est raccordée par au moins un canal de communication (12a-12c) aux capteurs de contrainte locaux (8a-8c) de l'échafaudage.

11. Procédé assisté par ordinateur pour la planification de l'agencement de capteurs de contrainte (8a-8c) dans une structure porteuse (1) ainsi que pour la surveillance ultérieure du fonctionnement d'une structure porteuse (1) avec les capteurs de contrainte (8a-8c) d'un système selon l'une quelconque des revendications précédentes, comprenant les étapes suivantes :
- fourniture (a) d'une planification statique (15) de la structure porteuse (1) devant être exécutée comme échafaudage ,
- identification (b) de zones de charge présentant un risque de surcharge dans la structure porteuse (1),
- sélection (c) de capteurs de contrainte (8a-8c) qui sont adaptés pour la saisie de contrainte sur des éléments de soutien (5a-5c) et/ou des éléments d'entretoises (6a-6d) et/ou des accouplements d'échafaudage (7) dans la zone de charge identifiée,
- positionnement (d) des capteurs de contrainte (8a-8c) sélectionnés au moins dans la partie de la structure porteuse (1) exposée à la contrainte, pour une
- saisie en continu (f) de données de mesure des capteurs de contrainte (8a-8c) dans la structure porteuse (1) par l'unité d'analyse (9),
- évaluation (g) des données de mesure saisies relativement aux situations de surcharge de la structure porteuse (1) pendant le fonctionnement,
- des données d'apprentissage étant stockées par l'unité d'analyse (9) reliée à l'unité de stockage (13), pour le soutien de planifications futures d'agencements de capteurs dans des structures porteuses (1) semblables ou similaires, de telle sorte que
- l'agencement futur de capteurs de contrainte (8a-8c) dans une structure porteuse (1) est prévu avec une unité de planification (14) accédant à l'unité de stockage (13), laquelle traite des données de dimensionnement de la planification statique (15).

12. Procédé selon la revendication 11,
**caractérisé en ce qu'**une détermination (e) de la liaison de données des capteurs de contrainte (8a-8c), positionnés en vue de la surveillance, avec l'unité d'analyse (9) devant y être raccordée est effectuée.

13. Procédé selon la revendication 11,
**caractérisé en ce que** les valeurs de mesure des capteurs de contrainte (8c) intégrés dans les éléments de soutien (5a-5c) ou disposés sur ceux-ci pour la surveillance de contrainte étendue sont évaluées de telle sorte qu'une présence et/ou un mouvement de personnes se trouvant sur la structure porteuse (1) conçue comme échafaudage ou une présence d'objets additionnels sur celle-ci sont déterminés.

14. Procédé selon la revendication 11,
**caractérisé en ce que** les valeurs de mesure des capteurs de contrainte (8c) intégrés dans les éléments de soutien (5a-5c) ou disposés sur ceux-ci pour la surveillance de contrainte étendue sont évaluées de telle sorte que des éléments de soutien (5a-5c) positionnés de façon non autorisée, en particulier inclinés de façon non autorisée sont identifiés par contrôle de vraisemblance.

15. Procédé selon la revendication 11,
**caractérisé en ce que,** par une comparaison des données de mesure de capteurs de contrainte (8c) d'éléments de soutien (5a-5c) voisins, l'avancement des travaux d'une charge répartie portée par ceux-ci est déterminé.

16. Procédé selon la revendication 11,
**caractérisé en ce que,** lors de l'apparition d'une situation de surcharge (h), un message d'alerte est sorti à l'attention du responsable (P) sur le chantier en vue de la prévention des risques.

17. Programme informatique, comprenant des commandes, lesquelles déclenchent l'exécution du procédé/des étapes du procédé selon la revendication 11 lors de l'exécution du programme par une unité de planification (14) assistée par ordinateur.

18. Programme informatique, comprenant des commandes, lesquelles déclenchent l'exécution du procédé/des étapes du procédé selon la revendication 11 lors de l'exécution du programme par une unité d'analyse (9) assistée par ordinateur.
